# EUROPÄISCHE PATENTSCHRIFT

(11) **EP 1 160 871 B1**
(45) Veröffentlichungstag und Bekanntmachung des Hinweises auf die Patenterteilung: **17.11.2004**
(21) Anmeldenummer: 01112152.2
(22) Anmeldetag: 17.05.2001
(51) Int. Cl.: H01L 29/06, H01L 29/78, H01L 21/336, H01L 21/306, H01L 21/20

(54) **Ladungskompensationshalbleiteranordnung und Verfahren zu deren Herstellung**
Charge compensation semiconductor device and method of making the same
Dispositif semi-conducteur à compensation de charge et sa méthode de fabrication

(30) Priorität: 30.05.2000 DE 10026924
(43) Veröffentlichungstag der Anmeldung: 05.12.2001
(73) Patentinhaber: Infineon Technologies AG, 81669 München (DE)
(72) Erfinder: Ahlers, Dirk, Dr., 80796 München (DE); Pfirsch, Frank, Dr., 81545 München (DE)
(74) Vertreter: Müller - Hoffmann & Partner

(56) Entgegenhaltungen:
- GB-A- 2 309 336
- US-A- 4 754 310

## Beschreibung

Die vorliegende Erfindung betrifft ein Kompensationshalbleiterbauelement sowie ein Verfahren zu dessen Herstellung. Kompensationshalbleiterbauelemente zeichnen sich bekanntlich dadurch aus, daß sie eine Driftstrecke aufweisen, die in Stromflußrichtung durch neben- oder übereinander angeordnete und einander abwechselnde n- und p-leitende Gebiete aufgebaut ist. Diese n-und p-leitenden Gebiete sind dabei so hoch dotiert, daß sich ihre Ladungen gegenseitig kompensieren und im Sperrfall die gesamte Driftstrecke an Ladungen ausgeräumt wird. Im Durchlaßfall tragen die n- und p-leitenden Gebiete aber deutlich höher als bei herkömmlichen Bauelementen Gebiete des einen Leitungstyps also beispielsweise n-leitende Gebiete, zum Stromfluß bei.

Kompensationshalbleiterbauelemente haben so bei hoher Sperrfähigkeit einen kleinen Einschaltwiderstand Ron.

Kompensationshalbleiterbauelemente lassen sich bekanntlich sowohl als Vertikalbauelemente als auch als Lateralbauelemente konzipieren (vgl. hierzu US 4 754 310, GB 2 309 336 und US 5 216 275). Bei Vertikalbauelementen befinden sich beispielsweise Sourceelektrode und Gateelektrode auf einer Oberseite eines Halbleiterkörpers, während die Drainelektrode auf der zur Oberseite gegenüberliegenden Unterseite angebracht ist. Die Kompensationsgebiete sind dann n- und p-leitende Schichten, auch Säulen genannt, die sich einander abwechselnd im Innern des Halbleiterkörpers in der Richtung zwischen Source und Drain erstrekken.

Bei Lateralbauelementen können in einem Halbleiterkörper zwei V-förmige Gräben oder Trenche eingebracht sein, von denen ein Trench die Sourceelektrode und die Gateelektrode aufnimmt, während der andere Trench für die Drainelektrode vorgesehen ist. Die Kompensationsgebiete sind hier als übereinander gelagerte und einander abwechselnde n- und p-leitende Schichten im Bereich des Halbleiterkörpers zwischen den beiden Trenchen vorgesehen.

Für die Herstellung von Kompensationshalbleiterbauelementen haben Vertikalstrukturen und Lateralstrukturen jeweils ihre eigenen Vor- und Nachteile:

Bei Vertikalstrukturen können die Sourceelektrode und die Drainelektrode auf den einander gegenüberliegenden Oberflächen des Halbleiterkörpers erheblich einfacher hergestellt werden als Source und Drain in Lateralstrukturen. Jedoch ist bei Vertikalstrukturen die Erzeugung der die Sperrspannung aufnehmenden Driftstrecke aus einander abwechselnden n- und p-leitenden Gebieten, die sich in vertikaler Richtung erstrecken, in Aufbautechnik durch mehrfache Epitaxie mit jeweils nachfolgender Ionenimplantation und Diffusion z. B. in der sogenannten CoolMOS-Technologie relativ aufwendig. Bei Lateralstrukturen lassen sich dagegen die einander abwechselnden n- und p-leitenden Kompensationsgebiete im Vergleich zur Aufbautechnik der Vertikalstrukturen viel einfacher herstellen, indem auf einen Halbleiterwafer nacheinander n- und p-leitende Schichten durch Epitaxie aufgetragen werden. Anstelle einer Epitaxie kann gegebenenfalls auch eine Dotierung durch Implantation vorgenommen werden. Problematisch bei Lateralstrukturen sind aber, wie bereits oben erwähnt wurde, die Anschlüsse von Source und Drain, da die die Kompensationsgebiete bildenden Schichten möglichst niederohmig mit Source bzw. Drain verbunden werden müssen, was bisher nur mit Hilfe einer aufwendigen Trenchtechnologie mit anschließender Füllung möglich ist.

Zusammenfassend ist also bei Vertikalstrukturen die Erzeugung der Driftstrecke sehr aufwendig, während bei Lateralstrukturen die Anschlüsse von Source und Drain erhebliche Probleme aufwerfen.

Infolge der oben aufgezeigten Schwierigkeiten werden bisher Kompensationshalbleiterbauelemente nur als Vertikaltransistoren hergestellt, wobei für den Aufbau der Driftstrecke mehrere Epitaxieschichten verwendet werden, in die jeweils mit Hilfe einer Implantation die im Endeffekt säulenartige Dotierung der n-und p-leitenden Gebiete eingebracht wird. Eine andere, ebenfalls aufwendige Methode zur Herstellung eines Vertikaltransistors besteht darin, für die Driftstrecke in sehr tief geätzte Trenches mittels verschiedener Verfahren die Dotierung einzubringen (vgl. US 4 754 310).

Es ist Aufgabe der vorliegenden Erfindung, ein Kompensationshalbleiterbauelement zu schaffen, bei dem Driftstrecke und Source- bzw. Drainanschluß auf einfache Weise herstellbar sind; außerdem soll ein vorteilhaftes Verfahren zum Erzeugen eines solchen Kompensationshalbleiterbauelementes angegeben werden.

Diese Aufgabe wird erfindungsgemäß durch ein Kompensationshalbleiterbauelement mit den Merkmalen des Patentanspruches 1 bzw. durch ein Verfahren mit den Merkmalen des Patentanspruches 8 gelöst.

Bei einem Feldeffekttransistor als Kompensationshalbleiterbauelement sind die beiden aktiven Zonen, zwischen denen sich die Driftstrecke ausdehnt, die Sourcezone und die Drainzone. Die die Driftzone bildende Schichtenfolge ist dann in der Richtung senkrecht zur Verbindungslinie zwischen Sourcezone und Drainzone gestapelt, wobei die einzelnen Schichten mit ihrer Längsausdehnung im Bereich zwischen der Sourcezone und der Drainzone verlaufen.

Vorteilhafte Weiterbildungen der Erfindung ergeben sich aus den Unteransprüchen.

Bei der vorliegenden Erfindung wird also mittels beispielsweise eines KOH-Ätzmittels in einen Silizium-Halbleiterkörper ein breiter Graben bzw. Trench geätzt. Der Silizium-Halbleiterkörper ist dabei entsprechend der gewünschten Spannung, für die das Kompensationshalbleiterbauelement eingesetzt werden soll, ausgewählt.

Das KOH-Ätzmittel hat bekanntlich die Eigenschaft, bei einem Siliziumkörper das Ätzen auf einer (111)-Ebene zu stoppen, während alle anderen Gitterebenen des Siliziums geätzt werden. Ein so auf einem (100)-Siliziumsubstrat entstehender Graben bzw. Trench weist daher eine Wandneigung von etwa 55° auf.

Auf den auf diese Weise vorbereiteten und mit einem Trench mit einer Wandneigung von etwa 55° versehenen Siliziumkörper werden abwechselnd p- und n-leitende Schichten aufgebracht, was durch dotierte Epitaxie oder durch Epitaxie und nachfolgende Implantation geschehen kann. Die Schichtdicke der einzelnen Schichten, die später die Driftstrecke bilden, kann dabei den Anforderungen an das Kompensationshalbleiterbauelement angepaßt werden. Grundsätzlich können die Schichten um so dünner sein, je geringer die Temperaturbelastung ist.

Nachdem in dem Graben bzw. Trench die gewünschte Anzahl von Schichten erzeugt ist, wird ein Planarisierungsschritt vorgenommen, bei dem die auf den Halbleiterkörper aufgetragenen Schichten zurück bis zu der ursprünglichen Oberfläche des Halbleiterkörpers oder Wafers abgetragen werden. Hier kann auch ein chemisch-mechanisches Polieren (CMP) oder eine anisotrope Ätzung eingesetzt werden.

Sollte noch ein Graben übriggeblieben sein, so wird dieser mit Oxid gefüllt. Es ist aber auch möglich, einen solchen "Restgraben" bereits bei den Epitaxieschritten mit niedrig dotiertem Silizium aufzufüllen.

Bei der so erhaltenen Struktur liegen nun an der Oberfläche des Halbleiterkörpers p- und n-leitende Gebiete nebeneinander und können ohne weiteres lateral miteinander verbunden werden. Diese Verbindungen können gleichzeitig für aktive Zonen beispielsweise eines Transistors verwendet werden. So kann quer zu den p- und n-leitenden Gebieten eine p-leitende Wanne, die später als Kanalzone dient, beispielsweise durch Implantation eingebracht werden. Über eine weitere Implantation kann sowohl die Sourcezone als auch der Anschluß für beispielsweise n-leitende Gebiete auf der Seite der Drainzone erfolgen. Schließlich wird noch eine Gateelektrode ebenfalls quer zu den p- und n-leitenden Gebieten in üblicher Weise hergestellt.

Ein Kompensationshalbleiterbauelement in Vertikalstruktur kann erzeugt werden, indem der Halbleiterkörper nach Füllen des Grabens bzw. Trenchs mit den p- und n-leitenden Schichten von dessen Rückseite her durch Schleifen und/oder Ätzen so weit gedünnt wird, daß schließlich beispielsweise n-leitende Gebiete von der Rückseite her direkt mit einem Metallkontakt oder indirekt über eine weitere n-leitende Schicht mit einem Drainanschluß verbunden werden können.

Bei dem erfindungsgemäßen Kompensationshalbleiterbauelement kann es sich in vorteilhafter Weise um einen MOS-Feldeffekttransistor, einen Junction-Feldeffekttransistor, einen IGBT, eine Schottky-Diode und so weiter, handeln.

Das Kompensationshalbleiterbauelement kann beispielsweise auf 600 V mit einer Driftzone mit einer Länge von 40 µm ausgelegt sein. Die n- und p-leitenden Gebiete haben dabei eine Dicke von etwa 2 µm und sind jeweils gleich hoch mit 1,5 E 16 cm⁻³ Ladungsträgern dotiert. Es können so Durchbruchsspannungen von etwa 630 V bei einem Einschaltwiderstand Ron zwischen Drain und Source von 7 Ohm mm² erreicht werden.

Die Dotierung in den einzelnen Schichten kann abhängig von dem gewünschten Anwendungsgebiet für das Kompensationshalbleiterbauelement variiert werden. Hierzu kann beispielsweise das elektrische Feld so aufgebaut werden, daß es in der ganzen Struktur aus den Schichten und nicht nur überwiegend an der Grenzfläche zu einer Oxidfüllung im Restgraben vorliegt. Außerdem ist es möglich, den längeren Weg des Stromes durch die tieferliegenden Schichten durch eine erhöhte Dotierung.in diesen Schichten und damit durch einen geringeren Widerstand zu kompensieren (vgl. hierzu auch US 4 754 310).

Nachfolgend wird die Erfindung anhand der Zeichnungen näher erläutert. Es zeigen:
- Fig. 1 bis 4: verschiedene schematische Schnittbilder, die die Herstellung des erfindungsgemäßen Kompensationshalbleiterbauelementes veranschaulichen,
- Fig. 5: eine vergrößerte Draufsicht auf einen lateralen Hochvolt-MOS-Transistor und
- Fig. 6: einen vergrößerten Teilschnitt AA in dem Transistor von Fig. 5.

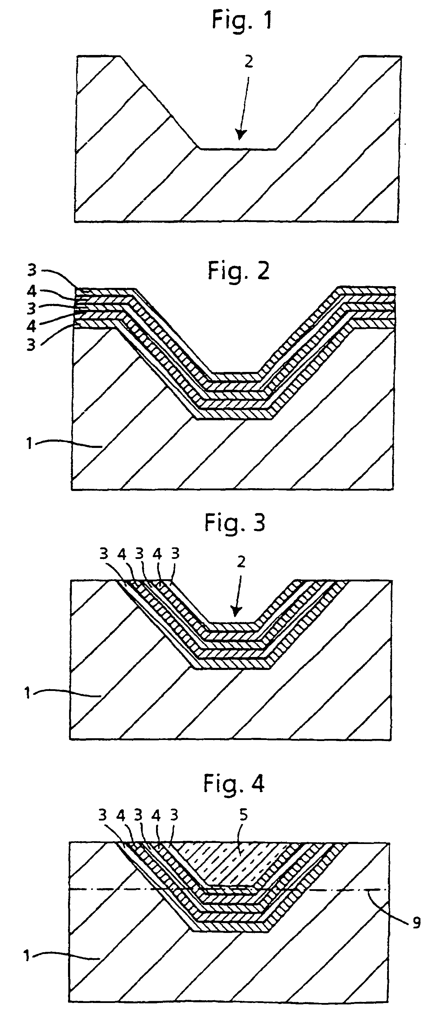

Fig. 1 zeigt einen Silizium-Halbleiterkörper 1 aus einem (100)-Siliziumsubstrat. In diesem Siliziumkörper 1 wird mit Hilfe eines KOH-Ätzmittels ein breiter Graben eingebracht. Das mit diesem Ätzmittel vorgenommene Ätzen stoppt auf einer (111)-Ebene, so daß ein trogförmiger Graben bzw. Trench 2 entsteht, dessen Wandneigung etwa 55° beträgt.

Gegebenenfalls können auch andere Ätzmittel außer KOH verwendet werden. Ein isotropes Ätzmittel führt beispielsweise zu einer U-Form des Grabens 2.

Bei der vorliegenden Erfindung braucht also der Graben 2 nicht eine Wandneigung von 55° aufzuweisen. Vielmehr sind auch andere Wandneigungen bis zu 90° möglich, so daß eine U-Form für den Graben vorliegt.

Der Siliziumkörper 1 kann undotiert sein. Er kann aber auch eine n-Dotierung oder eine p-Dotierung aufweisen, was letztlich davon abhängt, für welche Spannungen das fertige Kompensationshalbleiterbauelement eingesetzt werden soll.

Auf die in Fig. 1 gezeigte Struktur werden sodann nacheinander n-leitende Schichten 3 und p-leitende Schichten 4 entweder durch dotierte Epitaxie oder durch Epitaxie und nachfolgende Implantation oder sonstige Dotierung aufgebracht. Die Dicke dieser Schichten 3, 4 kann bei etwa 2 *µ*m liegen. Eine geeignete Dotierungskonzentration beträgt etwa 1,5 E 16 cm⁻³. Selbstverständlich sind aber auch andere Schichtdicken und Dotierungskonzentrationen möglich.

In dem Beispiel von Fig. 2 sind lediglich fünf Schichten 3, 4 gezeigt. Gegebenenfalls können jedoch noch mehr Schichten in den Graben 2 eingebracht werden, so daß dieser weitgehend mit diesen Schichten 3, 4, die einander abwechseln, gefüllt ist.

Nachdem die gewünschte Anzahl von Schichten 3, 4 in den Graben 2 bzw. auf den Siliziumkörper 1 aufgebracht ist, wird ein Planarisierungsschritt vorgenommen, bei dem die Schichten 3, 4 auf der Oberfläche des Siliziumkörpers 1 zurückgeätzt werden, so daß die in Fig. 3 gezeigte Struktur entsteht. Für diese Planarisierung kann gegebenenfalls auch ein CMP-Schritt und/oder eine anisotrope Ätzung eingesetzt werden. Auf diese Weise wird die in Fig. 3 gezeigte Struktur erhalten.

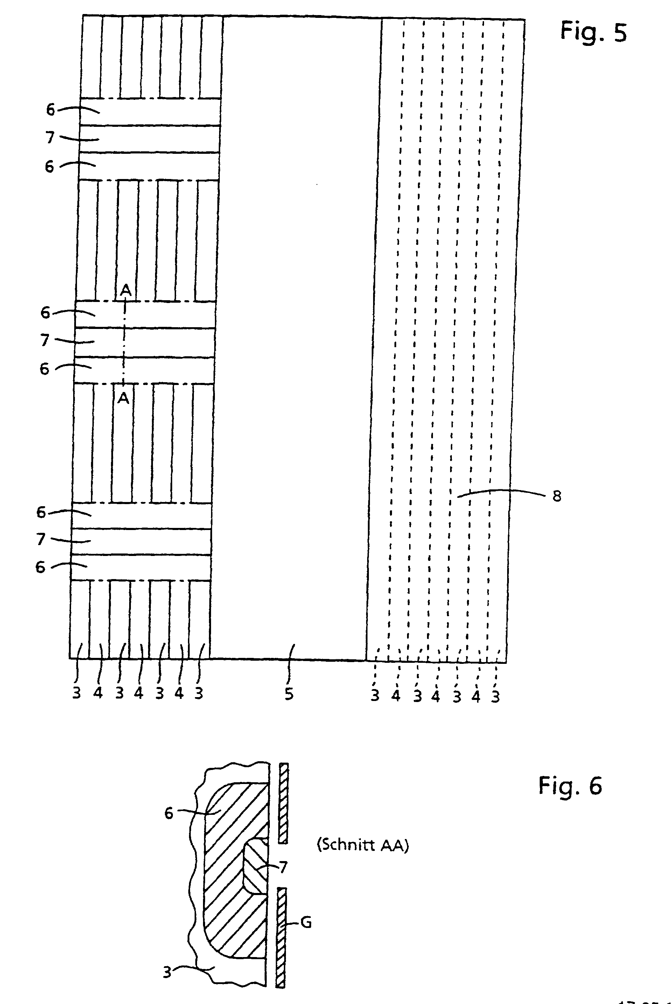

Der noch verbliebene Graben 2 wird sodann mit Siliziumdioxid oder einem anderen Isolierstoff gefüllt. Dieses Füllen des Restgrabens kann auch vor der Planarisierung vorgenommen werden oder aber ganz entfallen. Ebenso ist es aber auch möglich, nach den Epitaxieschritten zur Bildung der Schichten 3, 4 einen weiteren Epitaxieschritt folgen zu lassen, in welchem der Graben 2 mit niedrig dotiertem Silizium aufgefüllt wird. Es wird damit die in Fig. 4 gezeigte Struktur erhalten, bei der eine Oxidschicht 5 den Restgraben 2 füllt.

Bei einem U-förmigen Graben können die Schichten 3, 4 beispielsweise durch Schrägimplantation dotiert werden.

Bei der in Fig. 4 gezeigten Struktur liegen nun an der Oberfläche des Siliziumkörpers 1 die n-leitenden Schichten 3 und die p-leitenden Schichten 4 als n-leitende und p-leitende Gebiete nebeneinander und können lateral, also in Fig. 4 in Seitenrichtung, miteinander verbunden werden. Diese Verbindungen können gleichzeitig für Source-, Body- und Drain-Zonen eines MOS-Transistors verwendet werden.

So kann, wie aus der Draufsicht von Fig. 5 und dem Schnitt von Fig. 6 zu ersehen ist, quer zu den n- und p-leitenden Schichten 3 bzw. 4 eine p-leitende Wanne 6 implantiert werden, die bei dem fertigen Kompensationshalbleiterbauelement als Body-Zone bzw. Kanal dient. Über eine weitere Implantation können sodann sowohl eine Sourcezone 7 als auch eine Drainzone 8, die beide n-dotiert sind, eingebracht werden. Die Drainzone 8 dient als Anschluß für die n-leitenden Gebiete der Schichten 3 auf der Drainseite. Die p-leitenden Gebiete der Schichten 4 sind über die Bodyzone 6 angeschlossen. Eine Gateelektrode G kann ebenfalls quer zu den Schichten 3, 4 oberhalb der Bodyzone 6 auf einem Gateisolator aus beispielsweise Siliziumdioxid angebracht werden.

Soll ein Kompensationshalbleiterbauelement in Vertikalstruktur gebildet werden, dann wird die Struktur von Fig. 4 von der Rückseite her durch Schleifen und Ätzen soweit gedünnt, daß die n-leitenden Schichten 3 von der Rückseite her direkt mit einem Metallkontakt oder indirekt über eine weitere n-leitende Schicht mit einem Drainanschluß verbunden werden können. Dieses Dünnen ist in Fig. 4 durch eine Strichpunktlinie 9 angedeutet. Bei der auf diese Weise bis zu der Strichpunktlinie 9 gedünnten Struktur von Fig. 4 werden sodann die Bereiche links und rechts von der Isolatorfüllung 5 mit Transistorzellen sowie Source- und Gateanschluß versehen, was in gleicher Weise wie in Fig. 5 bzw. 6 erfolgen kann, während auf der Rückseite, also im Bereich der Strichlinie 9 der Drainanschluß angebracht wird.

### Bezugszeichenliste

- 1: Siliziumkörper
- 2: Trench bzw. Graben
- 3: n-leitendes Gebiet bzw. n-leitende Schicht
- 4: p-leitendes Gebiet bzw. p-leitende Schicht
- 5: Oxidfüllung
- 6: Bodyzone
- 7: Sourcezone
- 8: Drainzone
- 9: Strichpunktlinie für Dünnen von Siliziumkörper

## Patentansprüche

1. Kompensationshalbleiterbauelement mit einem trogförmigen Trench (2) und einer zwischen zwei aktiven Zonen vorgesehenen Driftstrecke, bestehend aus einer gestapelten Schichtenfolge aus p- und n-leitenden Gebieten (4, 3),
**dadurch gekennzeichnet, dass**
die Driftstrecke mit den p- und n-leitenden Gebieten (4, 3) um die Seitenflächen und die Bodenfläche des Trenches (2) geführt ist.

2. Kompensationshalbleiterbauelement nach Anspruch 1,
**dadurch gekennzeichnet, dass**
die Seitenflächen des Trenches (2) von der Bodenfläche aus im Wesentlichen schräg nach oben verlaufen, sodass die Öffnung des Trenches (2) breiter als die Bodenfläche ist.

3. Kompensationshalbleiterbauelement nach Anspruch 1 oder 2,
**dadurch gekennzeichnet, dass**
der Trench (2) zusätzlich zu den n- und p-leitenden Gebieten (3, 4) mit einer Oxidfüllung (5) versehen ist.

4. Kompensationshalbleiterbauelement nach einem der Ansprüche 1 bis 3,
**dadurch gekennzeichnet, dass**
die Wandneigung der Seitenflächen des Trenches (2) etwa 55° beträgt.

5. Kompensationshalbleiterbauelement nach einem der Ansprüche 1 bis 4,
**dadurch gekennzeichnet, dass**
es ein MOS-Feldeffekttransistor ist, bei dem die Sourcezone (7), die Bodyzone (6) und Gate (G) auf einer Seite des Trenches (2) und die Drainzone (8) auf der anderen Seite des Trenches oder bei dessen Bodenfläche vorgesehen sind.

6. Kompensationshalbleiterbauelement nach einem der Ansprüche 1 bis 4,
**dadurch gekennzeichnet, dass** es ein MOS-Feldeffekttransistor,ein Junction-Feldeffekttransistor, ein IGBT oder eine Schottky-Diode ist.

7. Verfahren zum Herstellen des Kompensationshalbleiterbauelementes nach einem der Ansprüche 1 bis 6,
**dadurch gekennzeichnet, dass**
- mittels eines anisotropen Ätzmittels ein trogförmiger Trench (2) in einen Halbleiterkörper (1) eingebracht wird,
- die Bodenfläche und die Seitenwände des Trenches (2) abwechselnd mit p- und n-leitenden Schichten (4, 3) versehen werden,
- die auf die Oberfläche des Halbleiterkörpers (1) dabei aufgetragenen Schichten (3, 4) in einem Planarisierungsschritt entfernt werden und
- der verbliebene Graben auf den Schichten (3, 4) mit einem Isolierstoff (5) oder Silizium gefüllt wird.

8. Verfahren nach Anspruch 7,
**dadurch gekennzeichnet, dass**
der Halbleiterkörper (1) von dessen Rückseite bis zu der untersten Schicht (3) unter der Bodenfläche des verbliebenen Trenches (2) gedünnt wird, um eine Vertikalstruktur der Driftstrecke zu erhalten.

9. Verfahren nach Anspruch 7 oder 8,
**dadurch gekennzeichnet, dass**
als Ätzmittel KOH verwendet wird.

10. Verfahren nach einem der Ansprüche 7 bis 9,
**dadurch gekennzeichnet, dass**
die p- und n-leitenden Schichten durch dotierte Epitaxie oder durch Epitaxie und Implantation hergestellt werden.

11. Verfahren nach einem der Ansprüche 7 bis 9,
**dadurch gekennzeichnet, dass**
zum Herstellen eines Feldeffekttransistors auf einer Seite des Trenches (2) quer zu den p- und n-leitenden Schichten (4, 3) eine Sourcezone (7) und eine Bodyzone (6) und auf der anderen Seite des Trenches (2) eine Drainzone (8) eingebracht werden.

## Claims

1. Compensation semiconductor component having a trough-shaped trench (2) and a drift path which is provided between two active zones and comprises a stacked sequence of layers of p-conducting and n-conducting regions (4, 3), **characterized in that** the drift path with the p-conducting and n-conducting regions (4, 3) is led around the side surfaces and the bottom surface of the trench (2).

2. Compensation semiconductor component according to Claim 1, **characterized in that** the side surfaces of the trench (2) run from the bottom surface essentially obliquely upward, so that the opening of the trench (2) is wider than the bottom surface.

3. Compensation semiconductor component according to Claim 1 or 2, **characterized in that**, in addition to the n-conducting and p-conducting regions (3, 4), the trench (2) is provided with an oxide filling (5).

4. Compensation semiconductor component according to one of Claims 1 to 3, **characterized in that** the wall inclination of the side surfaces of the trench (2) is approximately 55°.

5. Compensation semiconductor component according to one of Claims 1 to 4, **characterized in that** it is a MOS field-effect transistor, in which the source zone (7), the body zone (6) and gate (G) are provided on one side of the trench (2) and the drain zone (8) is provided on the other side of the trench or on its bottom surface.

6. Compensation semiconductor component according to one of Claims 1 to 4, wherein it is a MOS field-effect transistor, a junction field-effect transistor, an IGBT or a Schottky diode.

7. Process for producing the compensation semiconductor component according to one of Claims 1 to 6, **characterized in that**
- a trough-shaped trench (2) is introduced into a semiconductor body (1) by means of an anisotropic etching agent,
- the bottom surface and the side walls of the trench (2) are alternately provided with p-conducting and n-conducting layers (4, 3),
- the layers (3, 4) applied in this way to the surface of the semiconductor body (1) are removed in a planarizing step and
- the remaining groove on the layers (3, 4) is filled with an insulating material (5) or silicon.

8. Process according to Claim 7, **characterized in that** the semiconductor body (1) is thinned from its rear side as far as the lowermost layer (3) under the bottom surface of the remaining trench (2), in order to obtain a vertical structure of the drift path.

9. Process according to Claim 7 or 8, **characterized in that** KOH is used as the etching agent.

10. Process according to one of Claims 7 to 9, **characterized in that** the p-conducting and n-conducting layers are produced by doped epitaxy or by epitaxy and implantation.

11. Process according to one of Claims 7 to 9, **characterized in that**, for producing a field-effect transistor, a source zone (7) and a body zone (6) are introduced on one side of the trench (2) transversely to the p-conducting and n-conducting layers (4, 3) and a drain zone (8) is introduced on the other side of the trench (2).

## Revendications

1. Composant à semiconducteur à compensation, comprenant un sillon (2) en forme d'auget et une section de drift prévue entre deux zones actives et constitué d'une succession empilée de couches en régions (4, 3) de conductivité (p) et de conductivité (n),
**caractérisé en ce que** la section de drift ayant les régions (4, 3) de conductivité p et n passe autour des surfaces latérales et de la surface de fond du sillon (2)

2. Composant à semiconducteur à compensation suivant la revendication 1,
**caractérisé en ce que** les surfaces latérales du sillon (2) s'étendent à partir de la surface de fond en étant sensiblement inclinées vers le haut, de sorte que l'ouverture du sillon (2) est plus large que la surface du fond.

3. Composant à semiconducteur à compensation suivant la revendication 1 ou 2, **caractérisé en ce que** le sillon (2) est muni, en plus des régions (3, 4) de conductivité n et p d'un remplissage (5) d'oxyde.

4. Composant à semiconducteur à compensation suivant l'une des revendications 1 à 3, **caractérisé en ce que** l'inclinaison de la paroi des surfaces latérales du sillon (2) est d'environ de 55°.

5. Composant à semiconducteur à compensation suivant l'une des revendications 1 à 4, **caractérisé en ce que** c'est un transistor à effet de champs MOS, dans lequel les zones (7) de source, les zones (6) de corps et les grille (G) sont prévues d'un côté du sillon (2) et les zones (8) de drain sont prévues de l'autre côté du sillon ou de sa surface de fond.

6. Composant à semiconducteur à compensation suivant l'une des revendications 1 à 4 , **caractérisé en ce que** c'est un transistor à effet de champ MOS, un transistor à effet de champ à jonction, un IGBT ou une diode de Schottky.

7. Procédé de fabrication du composant à semiconducteur à compensation suivant l'une des revendications 1 à 6, **caractérisé en ce que**
- on ménage au moyen d'un agent d'attaque anisotrope un sillon (2) en forme d'auget dans un corps (1) semiconducteur,
- on munit la surface de fond et les parois latérales du sillon (2) en alternance de couches (4, 3) de conductivité p et n,
- on élimine dans un stade de planarisation les couches (3, 4) ainsi déposées sur la surface du corps (1) semiconducteur, et
- on emplit les sillons qui restent sur les couches (3, 4) d'une substance (5) isolante ou de silicium.

8. Procédé de fabrication, suivant la revendication 7,
**caractérisé en ce que**
on amincit le corps (1) semiconducteur par sa face arrière jusqu'à la couche (3) la plus inférieure sous la surface du fond du sillon (2) qui reste pour obtenir une structure verticale de la section de drift.

9. Procédé suivant la revendication 7 ou 8,
**caractérisé en ce que** l'on utilise de la KOH comme agent d'attaque.

10. Procédé suivant l'une des revendications 7 à 9, **caractérisé en ce que** l'on produit les couches de conductivité p et n par épitaxie dopée ou par épitaxie et implantation.

11. Procédé suivant l'une des revendications 7 à 9, **caractérisé en ce que** pour la production de transistor à effet de champ, on ménage d'un côté du sillon (2) transversalement aux couches (4, 3) de conductivité p et n, une zone (7) de source et une zone (6) de corps et de l'autre côté du sillon (2) une zone (8) de drain.
